Europäisches Patentamt

(19) European Patent Office

Office européen des brevets

(11) Numéro de publication: **0 196 556**
**B1**

(12) **FASCICULE DE BREVET EUROPÉEN**

(45) Date de publication du fascicule du brevet:
**13.09.89**

(21) Numéro de dépôt: **86103773.7**

(22) Date de dépôt: **20.03.86**

(51) Int. Cl.⁴: **G 01 R 31/08**

(54) **Procédé pour la mesure de la distance d'un défaut d'isolement sur une ligne et dispositif pour la mise en oeuvre du procédé.**

(30) Priorité: **25.03.85 FR 8504408**

(43) Date de publication de la demande:
**08.10.86 Bulletin 86/41**

(45) Mention de la délivrance du brevet:
**13.09.89 Bulletin 89/37**

(84) Etats contractants désignés:
**DE FR GB SE**

(56) Documents cité:
**EP-A-0 013 104**
**FR-A-2 309 877**

(73) Titulaire: **ALSTHOM, 38, avenue Kléber, F-75784 Paris Cédex 16 (FR)**

(72) Inventeur: **Ebersohl, Gérard, Les Acacias Chemin des Fontanières 282, F-69350 La Mulatière (FR)**
Inventeur: **Frayce, Yves, 50 chemin des Fonds, F-69110 Sainte Foy les Lyon (FR)**
Inventeur: **Ville, Jean- Claude, Route du Barrage, F-69510 Thurins (FR)**
Inventeur: **Moncorge, Jean- Paul, 229 Cours Emile Zola, F-69100 Villeurbanne (FR)**

(74) Mandataire: **Weinmiller, Jürgen, Lennéstrasse 9 Postfach 24, D-8133 Feldafing (DE)**

**Description**

La présente invention est relative à un procédé pour la mesure de la distance d'un défaut d'isolement sur une ligne électrique. Un tel procédé et un tel dispositif sont connus par exemple à partir du document FR-A-2 309 877. On y intègre dans le temps de signaux d'ondes progressives obtenus à partir de la mesure de la tension et de l'intensité de la ligne.

Par distance, on entend la mesure de la longueur entre l'origine de la ligne et le point de la ligne où survient un défaut.

Par défaut, on entend aussi bien un défaut monophasé à la terre qu'un défaut polyphasé isolé ou polyphasé à la terre.

Lorsqu'un défaut survient sur une ligne électrique, le système de protection génère un ordre de déclenchement appliqué aux disjoncteurs protégeant cette ligne. La tension de la ligne, en aval du disjoncteur s'annule alors selon une courbe sinusoïdale amortie. Il en est de même du des courants des diverses phases de la ligne.

Le fonctionnement de la présente invention repose sur la remarque qu'il existe, pour une ligne donnée, une relation mathématique entre la fréquence de l'onde d'oscillation amortie de la tension ou du courant de ligne et la distance de défaut, notamment lors de l'ouverture de la ligne en défaut.

On a pu vérifier lors d'essais que la distance du défaut calculable à partir de la pseudo-période de la tension ou du courant de la ligne après ouverture du disjoncteur correspond avec une très bonne précision à la distance réelle du défaut.

L'invention a donc pour objet un procédé pour la mesure de la distance d'un défaut d'isolement survenant sur une ligne électrique protégée par un disjoncteur caractérisé en ce que l'on mesure, après l'ouverture du disjoncteur la pseudo-période du courant ou de la tension de la ligne, la mesure de cette fréquence étant proportionnelle à la mesure de ladite distance. L'intérêt de cette mesure à l'ouverture du disjoncteur est que la fréquence des oscillations observables dans ce cas est strictement corrélée à la position du défaut affectant cette ligne. En effet, lorsque le disjoncteur est fermé, des oscillations amorties de tension ou courant sont observables sur une ligne mais qui peuvent provenir de défauts affectant des lignes adjacentes. On autre intérêt de l'invention est que la grandeur servant à la mesure est une fréquence et par conséquent, la distance calculable du défaut n'est pas affecté par la précision du réducteur.

Avantageusement, la mesure de la pseudopériode est effectuée par moyennage de plusieurs pseudo-périodes, après élimination d'au moins une pseudo-période immédiatement postérieure à l'ouverture du disjoncteur.

L'invention a également pour objet un dispositif pour la mesure de la distance d'un défaut survenant sur une ligne électrique protégée par un disjoncteur, caractérisé en ce qu'il comprend, au moins pour une phase, un transformateur placé en aval du disjoncteur et fournissant un signal image de la tension ou du courant de la ligne et un dispositif électronique recevant en entrée ledit signal, et fournissant en sortie une grandeur proportionnelle à la pseudo-période dudit signal.

L'invention sera bien comprise par les explications données ci-après en référence au dessin annexé dans lequel:

- la figure 1 est un schéma par blocs du dispositif de mesure selon un premier mode de réalisation à l'invention.
- la figure 2A est un diagramme représentatif du signal image de la tension de la ligne lors de la coupure d'un défaut.
- la figure 2B est un diagramme du même signal après équarissage.
- les figures 2C et 2F représentent respectivement le signal de temporisation, le signal de sortie du premier compteur, le signal de sortie du second compteur et le signal de commande du circuit d'affichage.
- la figure 3 est un schéma du dispositif de mesure selon un deuxième mode de réalisation.

L'invention repose sur l'observation que, pour une ligne donnée la fréquence de l'onde sinusoïdale amortie de courant ou de tension de la ligne après ouverture du disjoncteur est inversement proportionnelle à la distance d séparant le défaut du disjoncteur.

L'oscillation de la ligne se fait en quart d'onde de sorte que d est égal à v T/4 où v est la vitesse de propagation de la ligne et T la période de l'oscillation de la tension (ou du courant).

Pour une ligne donnée, la vitesse v peut être calculée ou mesurée. Elle dépend des caractéristiques de la ligne et des modes de propagation liés à la nature du défaut. Par exemple sur un type de ligne, l'onde aura, en cas de défaut monophasé une vitesse de propagation de 260 000 km/s et en cas de défaut triphasé, une vitesse de propagation de 291 500 km/s.

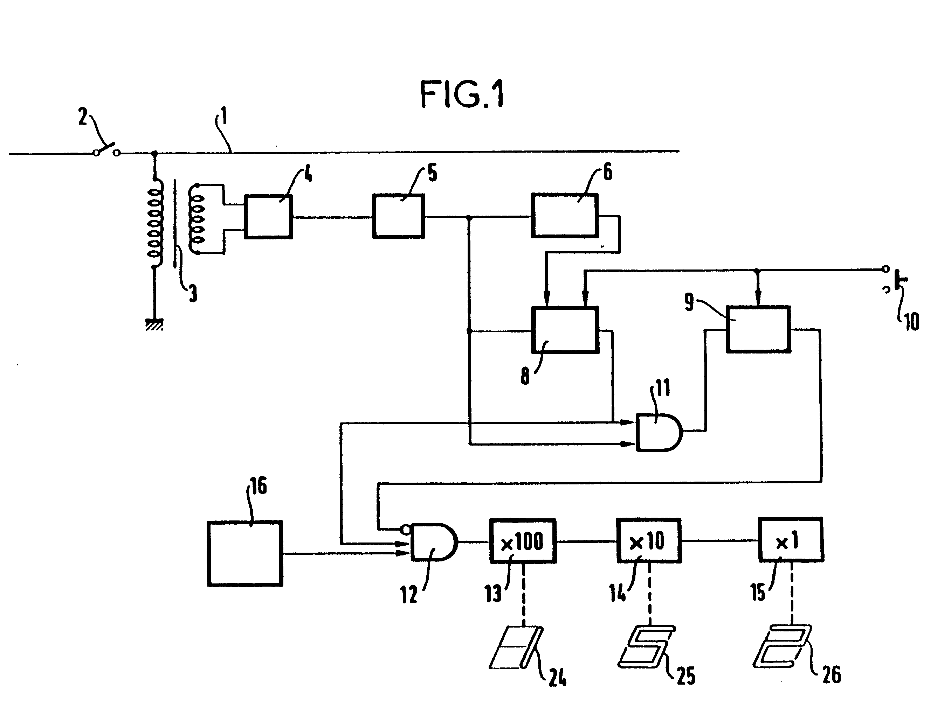

La figure 1 est un schéma par blocs d'un mode de réalisation de l'invention selon une solution analogique.

On a référencé 1 une phase de la ligne protégée par un disjoncteur 2. Un transformateur de tension 3 (ou un réducteur capacitif) fournit un signal image du courant de la ligne.

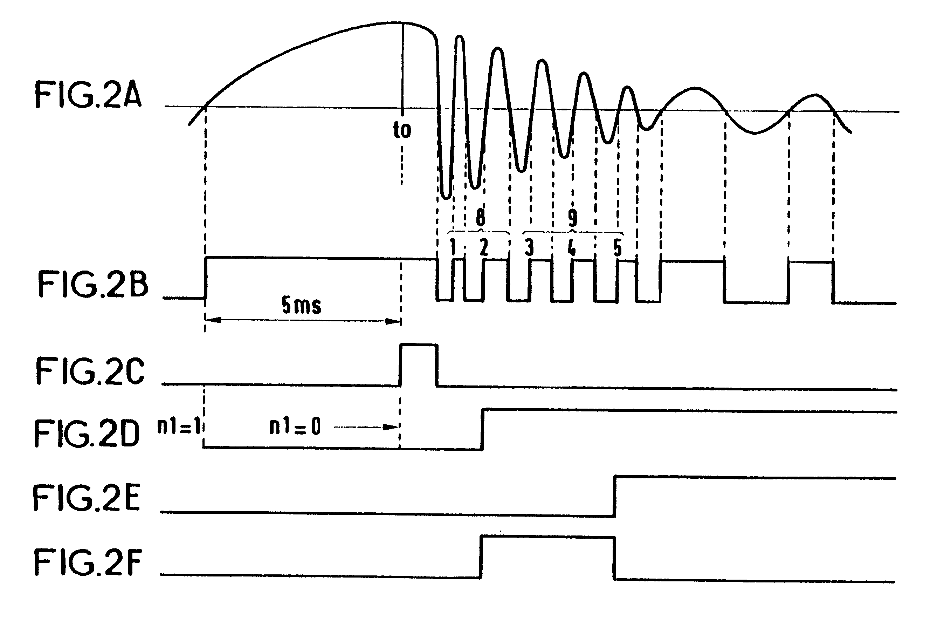

En se reportant à la figure 2A, qui est un diagramme du signal juste avant et après une ouverture du disjoncteur, on voit que le signal présente, après ouverture du disjoncteur, une forme sinusoïdale amortie. Après quelques oscillations (deux par exemple) un régime pseudopériodique s'établit, rapidement amorti. C'est la valeur de la pseudo-période qui est proportionnelle à la distance du défaut. Il est nécessaire, pour mettre en oeuvre le procédé, de résoudre les problèmes suivants:

a) initialiser le dispositif

b) éliminer les premières oscillations (par exemple les deux premières), qui ne sont pas caractéristiques du procédé et peuvent conduire à un résultat erronné.

c) déterminer un intervalle de mesure correspondant à un nombre entiers de pseudo-périodes. On choisira un compromis: plus le nombre de pseudo-périodes est élevé, plus grande est la précision de la mesure. Mais les oscillations s'amortissant vite, les dernières pseudo-périodes peuvent conduire à un résultat erronné et elles doivent être éliminées.

d) la mesure de la distance consiste à mesurer une pseudo-période moyenne.

Dans l'exemple décrit, on élimine les deux premières oscillations et on effectue la mesure sur un intervalle correspondant à trois pseudo-périodes.

Revenant au dispositif de la figure 1, le signal issu du transformateur 3 est filtré par un filtre passe-haut 4 pour éliminer la fréquence du réseau (50 Hz par exemple). On choisit une limite à 200 Hz par exemple. En sortie du filtre, le signal traverse un circuit équarrisseur 5 transformant le signal en signaux à fronts raides.

Le signal ainsi transformé est représenté dans la figure 2B. Le signal 2B est appliqué à l'entrée d'un circuit de temporisation 6 destiné à initialiser le système et fournissant un signal de remise à zéro du système dès que la durée du signal appliqué à son entrée dure plus que le temps de temporisation $t_T$ affiché. Le circuit est remis à zéro toutes les $t_T$ secondes.

Pour un réseau à 50 Hz, la temporisation $t_T$ est choisie égale à 5 millisecondes par exemple. En l'absence de défaut, le signal 2B est un signal de demi-période égale à 10 ms. Ce temps est supérieur à 5 ms de telle sorte que le système est remis à zéro.

Le signal de sortie du circuit de temporisation est présenté dans la figure 2C.

Le circuit de la figure 1 comprend un premier compteur 8, et un second compteur 9, en série avec le compteur 8 par l'intermédiaire d'un circuit ET 11. Une remise à zéro manuelle des compteurs peut être effectuée par un bouton-poussoir 10.

Le premier compteur 8 sert à l'élimination des n1 premières oscillations. Il est, dans l'exemple décrit, réglé pour éliminer les deux premières oscillations (n1 = 2) dont les fronts sont notés 1 et 2 dans la figure 2B. Ce compteur est remis à zéro par la sortie du circuit de temporisation 6.

Le compteur 8 ne fournit à l'entrée du circuit ET 11 un signal "1" (en logique positive) que lorsqu'il a compté deux fronts du signal. Le signal de sortie du compteur 8 est représenté dans le diagramme de la figure 2D.

Le second compteur 9 est réglé pour fournir en sortie un signal logique "1" lorsqu'il a compté n2 fronts du signal 2B. Dans l'exemple décrit n2 = 3. Le signal de sortie du compteur 9 est représenté dans le diagramme de la figure 2E.

La sortie du compteur 8 et la sortie du compteur 9 complémentée sont connectées, par un circuit ET 12, à un compteur formé de trois compteurs décimaux 13, 14 et 15 montés en cascades et correspondant respectivement aux centaines, aux dizaines et aux unités.

Une autre entrée du circuit ET 12 est alimentée par une horloge 16 fournissant des impulsions, comptées par le compteur 13, 14, 15 pendant l'intervalle défini sur la figure 2F; la fréquence de l'horloge 16 est avantageusement de 23 364 Hz. Cette valeur permet d'obtenir une indication directe de la distance qui peut être affichée en km. Pour cela les éléments 13, 14 et 15 du compteur sont avantageusement reliés à des dispositifs 23, 24 et 25 d'affichage, par exemple du type à 7 segments.

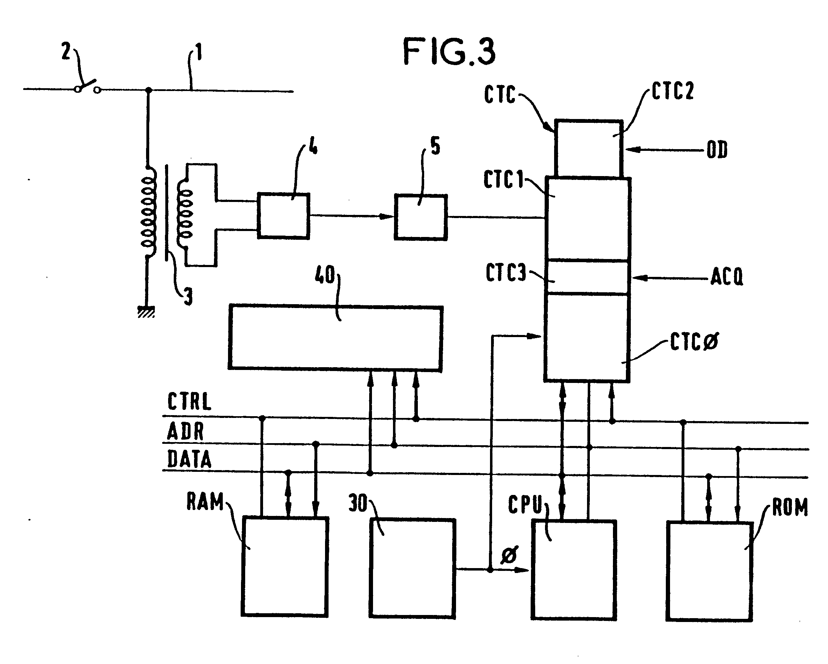

Le dispositif peut également être réalisé en version numérique, telle que celle représentée dans la figure 3.

On retrouve le transformateur 3, le filtre 4 et le circuit équarrisseur 5. Le circuit s'organise autour d'un circuit numérique compteur-horloge "CTC" à 4 éléments.

L'élément CTC 1 reçoit le signal; il est chargé à 1 et, à chaque transision "o" à "1" du signal, il déclenche une interruption à laquelle est associée un sous-programme SP1.

L'élément CTC 0 est attaqué par une horloge 30 à fréquence de l'ordre du MHz et provoque également toutes les n périodes d'horloge une interruption à laquelle est associée un sous-programme d'interruption SP2. Au cours de chaque interruption due à l'élément CTC1, la date du front est calculée dans le sous-programme SP1 par un calculateur programmé CPU. Des mémoires RAM et ROM peuvent être nécessaires.

La différence des dates successives est calculée et l'unité centrale, selon son programme, sélectionne les différences les plus significatives. Un dispositif d'affichage 40 permet d'afficher le résultat.

Le calculateur CPU, les mémoires ROM et RAM, le circuit d'affichage 30 et le circuit CTC sont reliés à une ligne classique comportant un bus de donnée (DATA) un bus d'adressage (ADR) et un bus de contrôle et de commande (CTRL).

L'élément CTC 2 du circuit CTC reçoit un signal OD d'initialisation à l'ouverture du disjoncteur.

L'élément CTC 3 reçoit un signal d'acquittement ACQ lorsque la lecture a été faite.

Avantageusement, chaque phase d'une ligne électrique triphasée sera munie d'un dispositif de localisation selon l'invention (soit en version numérique, soit en version analogique).

On pourra compléter ces dispositifs par un organe qui détermine le type du défaut et qui introduit une correction appropriée dans le résultat.

## Revendications

1. Procédé pour la mesure de la distance d'un défaut d'isolement survenant sur une ligne électrique protégée par un disjoncteur caractérisé en ce que l'on mesure, après l'ouverture du disjoncteur, la pseudo-période du courant ou de la tension de la ligne, la mesure de cette pseudo-période étant proportionnelle à la mesure de ladite distance.

2. Procédé selon la revendication 1 caractérisé en ce que la mesure de la pseudo-période est effectuée par moyennage de plusieurs pseudo-périodes, après élimination d'au moins une pseudo-période immédiatement postérieure à l'ouverture du disjoncteur.

3. Dispositif pour la mesure de la distance d'un défaut survenant sur une ligne protégée par un disjoncteur caractérisé en ce qu'il comprend, au moins pour une phase de la ligne, un transformateur (3) placé en aval du disjoncteur (2) et fournissant un signal image de la tension ou du courant de la ligne, et un dispositif électronique recevant en entrée ledit signal et fournissant en sortie une grandeur proportionnelle à la pseudo-période dudit signal.

4. Dispositif selon la revendication 3 caractérisé en ce que ledit signal image est envoyé sur un filtre passe-haut (4).

5. Dispositif selon l'une des revendications 3 ou 4 caractérisé en ce que ledit signal est adressé à un circuit équarrisseur (5).

6. Dispositif selon la revendication 5, caractérisé en ce que le signal (2B) de sortie du circuit équarrisseur (5) est envoyé sur un circuit de temporisation réglé à une valeur $t_T$ et sur un premier compteur (8) des fronts dudit signal de sortie (2B), ledit circuit de temporisation remettant ledit premier compteur (8) à zéro après un temps $t_T$, ledit premier compteur (8) fournissant en sortie un signal logique "1" lorsqu'il a compté un nombre n1 de fronts du signal (2B), ledit premier compteur (8) étant relié en sortie à une première entrée d'un premier circuit ET (11) recevant sur une autre entrée ledit signal (2B), la sortie du premier circuit "ET" (11) étant reliée à l'entrée d'un second compteur (9) fournissant en sortie un signal logique "1" lorsqu'il a compté un nombre n2 donné de fronts, la sortie du second compteur étant reliée à une entrée complémentée d'un second circuit "ET" (12) recevant sur une autre entrée des impulsions venant d'une horloge (16) et sur encore une autre entrée ledit signal de sortie du premier compteur (8), la sortie du second circuit "ET" (12) étant connectée à un troisième compteur (13, 14, 15).

7. Dispositif selon la revendication 6 caractérisé en ce que le troisième compteur (13, 14, 15) est associé à un organe (24, 25, 26) de visualisation.

8. Dispositif selon la revendication 5 caractérisé en ce que le signal de sortie (2B) du circuit équarrisseur (5) est adressé à un circuit numérique compteur-horloge (CTC) associé à un calculateur programmé (CPU) dont le programme calcule les durées entre les fronts du signal (2B) et sélectionne les valeurs les plus représentatives.

## Patentansprüche

1. Verfahren zur Messung des Abstands eines Isolationsfehlers auf einer durch einen Schalter geschützten elektrischen Leitung, dadurch gekennzeichnet, daß nach dem Öffnen des Schalters die Pseudoperiode des Stroms oder der Spannung der Leitung gemessen wird, wobei der Wert dieser Pseudoperiode proportional zu dem genannten Abstand ist.

2. Verfahren nach Anspruch 1, dadurch gekennzeichnet, daß die Messung der Pseudoperiode durch Mittelung mehrerer Pseudoperioden erfolgt, und zwar nach Eliminierung mindestens einer unmittelbar auf das Öffnen des Schalters folgenden Pseudoperiode.

3. Vorrichtung zur Messung des Abstands eines Fehlers auf einer Leitung, die durch einen Schalter geschützt ist, dadurch gekennzeichnet, daß sie für mindestens eine Phase der Leitung einen elektrisch hinter dem Schalter (2) liegenden Transformator (3), der ein die Spannung oder den Strom der Leitung abbildendes Signal liefert, und eine elektronische Vorrichtung aufweist, die eingangsseitig dieses Signal zugeführt erhält und ausgangsseitig eine Größe liefert, welche der Pseudoperiode dieses Signals proportional ist.

4. Vorrichtung nach Anspruch 3, dadurch gekennzeichnet, daß das abbildende Signal einem Hochpaßfilter (4) zugeführt wird.

5. Vorrichtung nach einem der Ansprüche 3 oder 4, dadurch gekennzeichnet, daß das Signal an eine Rechteckimpulsformerschaltung (5) geliefert wird.

6. Vorrichtung nach Anspruch 5, dadurch gekennzeichnet, daß das Ausgangssignal (2B) der Rechteckimpulsformerschaltung (5) an eine auf einen Wert $t_T$ eingestellte Verzögerungsschaltung sowie an einen ersten die Flanken dieses Ausgangssignals zählenden Zähler (8) übermittelt wird, wobei die Verzögerungsschaltung den ersten Zähler (8) nach Ablauf der Zeit $t_T$ auf Null zurückstellt, wobei der erste Zähler (8) am Ausgang ein logisches Signal "1" liefert, wenn er eine Anzahl von n1 Flanken des Signals (2B) gezählt hat, wobei der erste Zähler (8) ausgangsseitig mit einem ersten Eingang einer ersten UND-Schaltung (11) verbunden ist, die an einem anderen Eingang das Signal (2B) empfängt, wobei der Ausgang der ersten UND-Schaltung (11) an den Eingang eines zweiten Zählers (9) angeschlossen ist, der ausgangsseitig ein logisches Signal "1" liefert, wenn er eine vorgegebene Anzahl n2 von Stirnflanken gezählt hat, wobei der Ausgang des zweiten Zählers an einen komplementierten Eingang einer zweiten UND-Schaltung (12) angeschlossen ist, der über einen anderen Eingang Impulse eines Taktgebers (16) und über einem weiteren Eingang das Ausgangssignal des ersten Zählers (8) empfängt, und wobei der Ausgang der zweiten UND-Schaltung (12) mit einem dritten Zähler (13, 14, 15) verbunden ist.

7. Vorrichtung nach Anspruch 6, dadurch gekennzeichnet, daß der dritte Zähler (13, 14, 15) einem Sichtgerät (24, 25, 26) zugeordnet ist.

8. Vorrichtung nach Anspruch 5, dadurch gekennzeichnet, daß das Ausgangssignal (2B) der Rechteckimpulsformerschaltung (5) an eine digitale Taktzählerschaltung (CTC) geliefert wird, die einem programmierten Rechner (CPU) zugeordnet ist, dessen Programm die Zeitdauer zwischen den Stirnflanken des Signals (2B) berechnet und die repräsentativsten Werte auswählt.

**Claims**

1. A method of measuring the distance to an insulation fault occurring on an electricity line protected by a circuit breaker, the method being characterized in that after the circuit breaker has opened, the pseudo-period of the line voltage or current is measured, with said pseudo-period being proportional to the measure of said distance.

2. A method according to claim 1, characterized in that the pseudo-period is measured by averaging over a plurality of pseudo-periods after eliminating at least one pseudo-period immediately after the circuit breaker opens.

3. Apparatus for measuring distance to a fault occurring on a line protected by a circuit breaker, the apparatus being characterized in that it comprises, for at least one phase of the line, a transformer (3) placed downstream from the circuit breaker (2) and providing a signal which is an image of the voltage or the current on the line, and an electronic circuit receiving said signal as an input signal and providing an output magnitude which is proportional to the pseudo-period of said signal.

4. Apparatus according to claim 3, characterized in that said image signal is passed through a high-pass filter (4).

5. Apparatus according to claim 3 or 4, characterized in that said signal is applied to a squaring circuit (5).

6. Apparatus according to claim 5, characterized in that the output signal (2B) from the squaring circuit (5) is applied to a timing circuit adjusted to a value $t_T$ and to a first counter (8) for counting edges in said output signal (2B), said timing circuit resetting said first counter (8) to zero after a time lapse $t_T$, said first counter (8) providing a logic level "1" output signal when it has counted a number, n1, of edges in the signal (2B), said first counter (8) having its output connected to a first input of a first AND gate (11) whose other input receives said signal (2B), the output from the first AND gate (11) being connected to the input of a second counter (9) providing a logic level "1" output signal when it has counted a given number n2 of edges, the output from the second counter being connected to a complemented input of a second AND gate (12) having another input connected to receive pulses from a clock (16) and having yet another input connected to receive said output signals from the first counter (8), with the output from the second AND gate (12) being connected to a third counter (13, 14, 15).

7. Apparatus according to claim 6, characterized in that the third counter (13, 14, 15) is associated with a display member (24, 25, 26).

8. Apparatus according to claim 5, characterized in that the output signal (2B) from the squaring circuit (5) is applied to a digital counter/clock circuit (CTC) associated with a programmed computer (CPU) whose program calculates durations between edges in the signal (2B) and selects the most representative values.

FIG.1

EP 0 196 556 B1

FIG.2A

FIG.2B

5ms

FIG.2C

FIG.2D  n1=1  n1=0

FIG.2E

FIG.2F

t0

8

9

1  2  3  4  5

# FIG.3

EP 0 196 556 B1